Europäisches Patentamt

European Patent Office

Office européen des brevets

(19)

(11) Veröffentlichungsnummer: **0 044 047**
**B1**

(12) **EUROPÄISCHE PATENTSCHRIFT**

(45) Veröffentlichungstag der Patentschrift: 07.05.86

(51) Int. Cl.⁴: **H 03 K 17/90**

(21) Anmeldenummer: **81105360.2**

(22) Anmeldetag: **09.07.81**

(54) Schaltungsanordnung zur Erhöhung des auswertbaren Hall-Signals eines Hall-Sensors.

(30) Priorität: **10.07.80 DE 3026226**

(43) Veröffentlichungstag der Anmeldung:
**20.01.82 Patentblatt 82/03**

(45) Bekanntmachung des Hinweises auf die
Patenterteilung:
**07.05.86 Patentblatt 86/19**

(84) Benannte Vertragsstaaten:
**DE FR GB IT**

(56) Entgegenhaltungen:
**DE-B-2 407 421**
**US-A-3 848 252**

**ELECTRICAL COMMUNICATION, Band 54, Nr.
1, Januar 1979, Seiten 51-55 Harlow, Essex,
G.B. A.W. SWEET: "Electronic replacements for
relays"**

**IEEE SPECTRUM, Band 9, Nr. 7, Juli 1972, Seite
72 New York, U.S.A. "Hall.effect integrated
circuits enlarge the area of magnetic switching
applications"**

(73) Patentinhaber: **Siemens Aktiengesellschaft
Berlin und München Wittelsbacherplatz 2
D-8000 München 2 (DE)**

(72) Erfinder: **Gehring, Gerhard, Dipl.-Ing.
Geschw.-Scholl-Strasse 7
D-8025 Unterhaching b.München (DE)**

EP 0 044 047 B1

## Beschreibung

Die vorliegende Erfindung betrifft eine Schaltungsanordnung zur Erhöhung des auswertbaren Hall-Signals eines Hall-Sensors mit N mit eingeprägtem Steuerstrom betriebenen Hall-Generatoren und mit an die Hall-Signalstrecke der Hall-Generatoren angekoppelten Spannungs-Strom-Wandlern.

Hall-Generatoren werden vorzugsweise mit konstantem (eingeprägtem) Steuerstrom betrieben, weil dann die Hall-Spannung unabhängig von der Beweglichkeit der Ladungsträger im Halbleitermaterial ist. Um ein möglichst großes Hall-Signal zu erhalten, wird ein hochohmiges Halbleitermaterial, das heißt, ein Halbleitermaterial mit kleiner Dotierung verwendet.

In integrierten Schaltkreisen realisiert man daher Hall-Generatoren immer im hochohmigsten im Schaltkreis vorkommenden Material. Dies ist in den Kollektorwannen von integrierten Schaltkreisen der Fall. Darüber hinaus wählt man Technologien, die besonders hochohmige Kollektorwannen ergeben. Für die Transistoren ergeben sich dann besonders hohe Durchbruchspannungen.

Der Konstantstrom-Betrieb läßt sich im allgemeinen nur durch eine aktive Regelschaltung realisieren, wobei eine sehr gute Unabhängigkeit von der Versorgungsspannung und der Temperatur erhalten wird.

Bei den durch den praktischen Betrieb gegebenen Bedingungen ergeben sich allerdings einige sehr störende Einschränkungen.

1. Es muß in vielen Fällen eine Funktionsbereitschaft mit Betriebsspannungen bis hinunter zu 4,3 Volt garantiert werden;

2. Es können im praktischen Betrieb Temperaturen von −40° Celsius bis +120° Celsius auftreten;

3. In einer Reihe von Anwendungen ist die Stromaufnahme von Hall-Generator und Auswerteeletronik auf 3 mA beschränkt.

Der Hall-Generator-Querwiderstand beträgt unter den gegebenen Voraussetzungen bei etwa quadratischer Form des Hall-Generator-Elementes zwei bis drei kOhm. Mit einem Temperaturkoeffizienten von etwa 0,8 %/K und einer maximalen Temperatur von 120° ist mit einer Verdopplung dieses Wertes unter praktischen Betriebsbedingungen zu rechnen.

Um bei der niedrigsten zu berüchsichtigenden Betriebsspannung von 4,3 Volt noch arbeiten zu können, ist nur ein maximaler Strom von kleiner 1 mA durch den Hall-Generator möglich. Damit ist die Höhe der maximal erreichbaren Signalspannung festgelegt. Um bei der minimalen Betriebsspannung noch arbeiten zu können kann der Steuerstrom des Hall-Generators dadurch erhöht werden, daß der Hall-Generator-Widerstand durch Erhöhung der Breite des Hall-Generator-Elementes erniedrigt wird, weil der Hall-Generator-Quer-Widerstand umgekehrt proportional zur Breite des Hall-Generator-Elementes ist.

Durch diese Maßnahme ergibt sich jedoch nur eine geringfügige Hall-Signalerhöhung, weil der sogenannte Geometriekorrekturfaktor des Hall-Generators etwa bei einer Halbierung des Längen- zur Breitenverhältnisses nur von etwa 0,7 auf 0,4 fällt. Bei einer Verdopplung des Steuerstromes ergibt sich also nur ein Signalgewinn von ca. 14%.

Aus "Electrical Communication", Band 54, Nr. 1, Januar 1979, Seiten 51 bis 55 sind Schaltungsanordnungen mit einer Vielzahl von Hall-Generatoren bekannt, bei denen eine Erhöhung des auswertbaren Hall-Signals möglich ist. Dabei wird jedoch speziell zwei Hall-Generatoren ein gegengekoppelter Differenzverstärker nachgeschaltet, wobei jeweils ein Anschluß der Hall-Signalstrecken über jeweils einen Widerstand auf den invertierenden Eingang und der jeweils andere Anschluß der Hall-Signalstrecken über jeweils einen Widerstand an den nichtinvertierenden Eingang angekoppelt ist. Dieser nichtinvertierende Eingang liegt dabei über einen Widerstand an Masse. Mit einer derartigen Schaltungsanordnung erfolgt eine nachrichtentechnische Addition/Subtraktion ohne Rücksicht auf zu beachtende statistische Störkreise (Rauschen, Driften), gegen die ein Mindestabstand aufrecht zu erhalten ist. Lediglich der Kreis des invertierenden Eingangs des Differenzverstärkers mit dem jeweiligen Vorwiderstand von Hall-Sensor und dem Gegenkopplungswiderstand könnte als Spannungs-Strom-Wandlerstrecke angesehen werden. Dies gilt nicht für den Kreis des nichtinvertierenden Eingangs des Differenzverstärkers. Am nichtinvertierenden Eingang des Differenzverstärkers ergibt sich nämlich eine Spannungsteilung des von den Hall-Sensoren kommenden Signalanteils zwischen dem jeweiligen Vorwiderstand von einer Hall-Signalstrecke und dem gegen Masse geschalteten Widerstand. Der Differenzverstärker verstärkt lediglich die mit Widerstandsbrüchen behaftete Differenz der Eingangsspannung, so daß sich auch lediglich eine Addition von Bruchteilen der Hall-Spannungen unter Berücksichtigung der Widerstandsverhältnisse ergibt. Diese Schaltungsanordnung ist darüber hinaus vorzugsweise auch nur für zwei Hall-Sensoren geeignet, weil bei Ankopplung von jeweils mehr als zwei Hall-Sensoren an die beiden Eingänge des Differenzverstärkers auf der Seite des invertierenden Eingangs eine Entkopplung der Eingangssignale möglich ist, während dies auf der Seite des nichtinvertierenden Eingangs aufgrund der Signalverkopplung über den nach Masse geschalteten Widerstand nicht möglich ist.

Aus der US—A—3 916 215 ist eine Logik-Schaltungsanordnung bekannt geworden, bei der Ausgänge mehrerer Schaltungsstuffen zu einem gemeinsamen Ausgang zusammengefaßt sind, wobei es sich um eine seit langem übliche Methode handelt, um über hochohmige Kollektorausgänge eine Entkopplung zu realisieren. Bei einer derartigen Verkopplung der Ausgänge von digitalen Gatterstufen wird eine digitale Überlagerung von Schaltsignalen, nicht aber eine analoge Signalüberhöhung erzielt.

Aus "IEEE Spectrum, Band 9, Nr. 7, Juli 1972, Seite 72 ist es bekannt, einem einzigen Hall-Sensor einen Differenzverstärker nachzuschalten, wobei die Hall-Strecke des Hall-Sensors an die beiden Eingänge des Differenzverstärkers angekoppelt ist. Dies stellt lediglich eine einfache Verstärkung des Hall-Signals eines einzigen Hall-Sensors dar.

Der vorliegenden Erfindung liegt die Aufgabe zugrunde, eine Schaltungsanordnung der in Rede stehenden Art mit erhöhtem auswertbarem Hall-Signal bzw. erhöhtem Signalgewinn zu realisieren.

Diese Aufgable wird bei einer Schaltungsanordnung der eingangs genannten Art erfindungsgemäß dudurch gelöst, daß N Spannungs-Strom-Wandler vorgesehen sind, von denen jeweils einer an die Hall-Signalstrecke jeweils eines Hall-Generators angekoppelt ist und daß die Ausgänge der Spannungs-Strom-Wandler zum Zwecke der Addition ihrer Ausgangsströme zusammengeschaltet sind.

Ausgestaltungen des Erfindungsgedankens sind in Unteransprüchen gekennzeichnet.

Die Erfindung wird im folgenden anhand von in den Figuren der Zeichnung dargestellten Ausführungsbeispielen näher erläutert. Es zeigt:

Figur 1 ein Blockschaltbild einer grundsätzlichen Ausführungsform einer erfindungsgemäßen Schaltungsanordnung;

Figur 2 ein Schaltbild einer Ausführungsform der erfindungsgemäßen Schaltungsanordnung mit Differenzverstärkern in einer Auswerteschaltung und

Figur 3 eine abgewandelte Form der Schaltungsanordnung nach Figur 2.

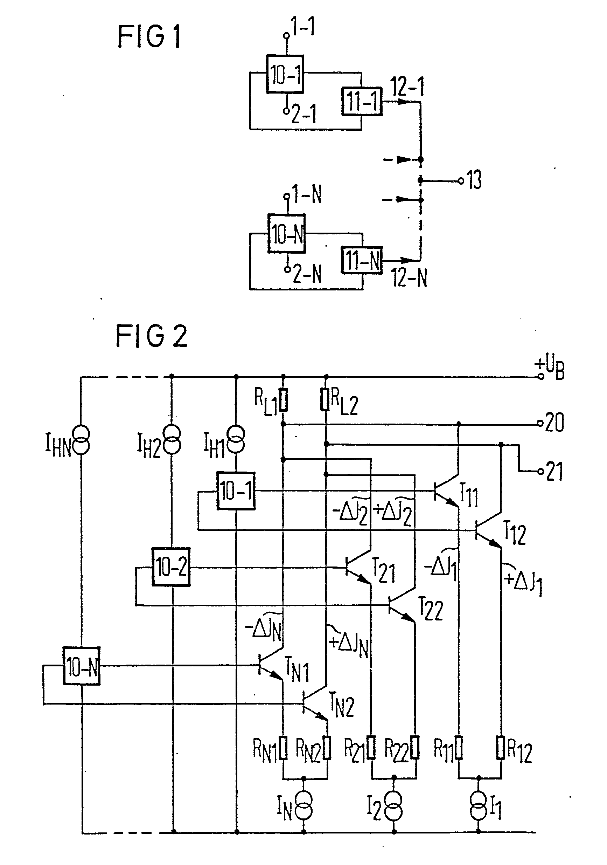

Gemäß Figur 1 sind in einer erfindungsgemäßen Schaltungsanordnung allgemein N-Hall-Generatoren 10-1, 2-1, ... 1-N, 2-N vorgesehen, in die über Anschlüsse 1-1, 2-1, ... 1-N, 2-N jeweils ein Steuerstrom eingeprägt wird. An die Hall-Strecke der Hall-Generatoren 10-1 ist 10-N ist jeweils ein Stromwandler 11-1 bis 11-N angekoppelt. Ausgänge 12-1 bis 12-N dieser Stromwandler 11-1 bis 11-N sind zu einem gemeinsamen Ausgang 13 zusammengeschaltet. Da sich somit die Ausgangsströme der Spannungs-Strom-Wandler 11-1 bis 11-N addieren, läßt sich eine N-fache Erhöhung des auswertbaren Ausgangssignals der Hall-Generatoren 10-1 bis 10-N realisieren.

Gemäß der Ausführung nach Figur 2 sind die Spannungs-Strom-Wandler der Schaltungsanordnung nach Figur 1 als Differenzverstärker ausgebildet, welche jeweils Transistoren $T_{11}$, $T_{12}$; $T_{21}$, $T_{22}$ bis $T_{N1}$, $T_{N2}$ enthalten. Die Emitter der Transistoren in den Differenzverstärkern liegen über jeweils einen Emitterwiderstand $R_{11}$, $R_{12}$; $R_{21}$, $R_{22}$ bis $R_{N1}$, $R_{N2}$ an einer Konstantstromquelle $I_1$, $I_2$ bis $I_N$. Allen Differenzverstärkern gemeinsam sind zwei Lastwiderstände $R_{L1}$ und $R_{L2}$

enthaltende Ausgangszweige, welche auf Ausgangsklemmen 20 und 21 der Schaltungsanordnung geführt sind. Die Kollektoren der Differenzverstärker-Transistoren sind derart an die Ausgangszweige gekoppelt, daß sich jeweils Signalströme gleicher Phasenlage addieren. So addieren sich Signalströme $-\Delta I_1$, $-\Delta I_2$ bis $-\Delta I_N$ der Transistorkreise $T_{11}$, $T_{21}$ bis $T_{N1}$ im Ausgangszweig des Lastwiderstandes $R_{L1}$, während sich Signalströme $+\Delta I_1$, $+\Delta I_2$, $+\Delta I_N$ der Transistorzweige $T_{12}$, $T_{22}$ bis $T_{N2}$ im Ausgangszweig des Lastwiderstandes $R_{L2}$ addieren.

Somit werden also die Ausgangssignale an den Hall-Strekken der Hall-Generatoren 10-1, 10-2 bis 10-N denen über Konstantstromquellen $I_{H1}$, $I_{H2}$ bis $I_{HN}$ jeweils ein Steuerstrom eingeprägt wird, addiert, da die Signalströme $\Delta I$ der Differenzverstärker jeweils in dem gemeinsamen Lastwiderstand $R_{L1}$ bzw. $R_{L2}$ addiert werden. Da die Kollektorströme eines Transistors wegen der am Kollektor zu messenden sehr hohen Ausgangsimpedanz praktisch eingeprägt sind, wird die Addition der Kollektorströme praktisch ohne gegenseitige Rückwirkung einfach durch Verbinden der entsprechenden Kollektoren an den Lastwiderständen $R_{L1}$ und $R_{L2}$ erreicht.

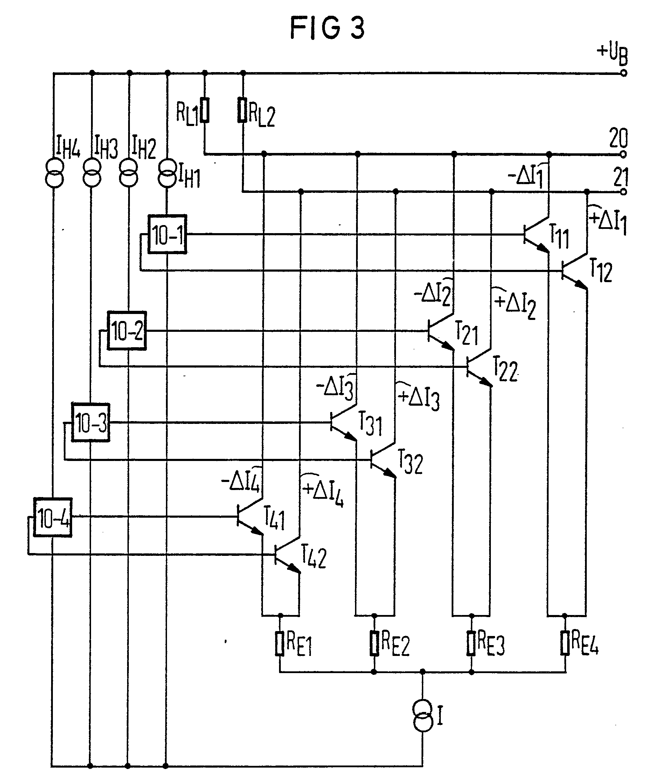

Gemäß der Ausführungsform nach Figur 3, in der gleiche Elemente wie in Figur 2 mit gleichen Bezugszeichen versehen sind, läßt sich eine Vereinfachung dadurch erreichen, daß man die Emitter der Differenzverstärker-Transistoren direkt zusammenschaltet und über jeweils einen gemeinsamen Emitterwiderstand $R_{E1}$, $R_{E2}$ bis $R_{EN}$ auf eine gemeinsame stromeinprägende Konstantstromquelle I führt.

Anhand der vorstehend erläuterten Ausführungsbeispiele wird ersichtlich, daß sich erfindungsgemäß die Signalspannungen (Hall-Spannungen) nahezu beliebig vieler Hall-Generatoren summieren lassen. Man erhält somit einerseits höhere Auswertesignale, die auch die Analysierung kleinerer Signale erlauben wobei sich bei der Addition mehrerer statistisch streuender Fehler oder Null-Komponenten nur deren quandratischer Mittelwert ergibt.

**Patentansprüche**

1. Schaltungsanordnung zur Erhöhung des auswertbaren Hall-Signals eines Hall-Sensors mit N mit eingeprägtem Steuerstrom betriebenen Hall-Generatoren und mit an die Hall-Signalstrecke der Hall-Generatoren angekippelten Spannungs-Strom-Wandlern, dadurch gekennzeichnet, daß N Spannungs-Strom-Wandler (11-1, 11-2,..., 11-N) vorgesehen sind, von denen jeweils einer an die Hall-Signal-strecke jeweils eines Hall-Generators (10-1, 10-2..., 10-N) angekoppelt ist und daß die Ausgänge (12-1, 12-2,..., 12-N) der Spannungs-Strom-Wandler (11-1, 11-2,..., 11-N) zum zwecke der Addition ihrer Ausgangsströme zusammengeschaltet sind.

2. Schaltungsanordnung nach Anspruch 1, dadurch gekennzeichnet, daß die Spannungs-Strom-Wandler (11-1, 11-2,... 11-N) als Differenzverstärker ausgebildet sind und daß jeweils die Signalströme gleicher Phasenlage führenden Ausgangszweige der Differenzverstärker zusammengeschaltet sind.

3. Schaltungsanordnung nach Anspruch 1 und 2, dadurch gekennzeichnet, daß die Emitter Transistoren ($T_{11}$, $T_{12}$; $T_{21}$, $T_{22}$;...; $T_{N1}$, $T_{N2}$) über jeweils einen Emitterwiderstand ($R_{11}$, $R_{12}$; $R_{21}$, $R_{22}$;...; $R_{N1}$, $R_{N2}$) an jeweils einer Konstantstromquelle ($I_1$, $I_2$,..., $I_N$) liegen.

4. Schaltungsanordnung nach Anspruch 1 und 2, dadurch gekennzeichnet, daß die Emitter der Transistoren ($T_{11}$, $T_{12}$; $T_{21}$, $T_{22}$; ... ; $T_{N1}$, $T_{N2}$) jeweils eines Differenzverstärkers direkt gekoppelt und über einen gemeinsamen Emitterwiderstand ($R_{E1}$, $R_{E2}$, ... $R_{EN}$) an einer gemeinsamen Konstantstromquelle (I) liegen.

## Claims

1. A circuit arrangement for increasing the effective signal of a Hall-sensor having N Hall-generators operated by an impressed control current, and with voltage-current converters coupled to the Hall signal path of the Hall-generators, characterised in that N voltage-current converters (11-1, 11-2 ..., 11-N) are provided, each of which is coupled to the Hall signal path of a Hall-generator (10-1, 10-2, ..., 10-N) and that the outputs (12-1, 12-2, ..., 12-N) of the voltage-current converters (11-1, 11-2, ..., 11-N) are interconnected for the addition of their output currents.

2. A circuit arrangement as claimed in Claim 1, characterised in that the voltage-current converters (11-1, 11-2 ..., 11-N) are designed as differential amplifiers, and that the differential amplifier output arms which each carry signal currents of the same-phase position are interconnected.

3. A circuit arrangement as claimed in Claim 1 and Claim 2, characterised in that the emitters of transistors ($T_{11}$, $T_{12}$; $T_{21}$, $T_{22}$; ...; $T_{N1}$, $T_{N2}$) are each connected via an emitter resistor ($R_{11}$, $R_{12}$; $R_{21}$, $R_{22}$; ...; $R_{N1}$, $R_{N2}$) to a constant current source ($I_1$, $I_2$, ..., $I_N$) in each case.

4. A circuit arrangement as claimd in Claim 1 and Claim 2, characterised in that the emitters of the transistors ($T_{11}$, $T_{12}$; $T_{21}$, $T_{22}$; ...; $T_{N1}$, $T_{N2}$) of each differential amplifier are directly coupled and are connected via a common emitter-resistor ($R_{E1}$, $R_{E2}$, ..., $R_{EN}$) to a common constant current source (I).

## Revendications

1. Montage pour l'augmentation du signal de Hall exploitable d'un capteur de Hall comportant N générateurs de Hall opérant avec un courant de commande indépendant de la charge, et des convertisseurs tension-courant couplés aux pistes de transmission des signaux de Hall, caractérisé par le fait qu'il est prévu N convertisseurs tension-courant (11-1, 11-2, ..., 11-N), dont chacun est couplé respectivement à la voie de transmission des signaux de Hall d'un générateur de Hall associé (10-1, 10-2, ..., 10-N), et que les sorties (12-1, 12-2, ..., 12-N) des convertisseurs tension-courant (11-1, 11-2, ..., 11-N) sont reliées entre elles en vue de l'addition de leurs courants de sortie.

2. Montage selon la revendication 1, caractérisé par le fait que les convertisseurs tension-courant (11-1, 11-2, ..., 11-N) sont réalisés sous la forme d'amplificateurs différentiels, et que les branches de sortie de ces derniers, qui sont parcourues par des courants de signaux de même phase, sont reliées entre elles.

3. Montage selon la revendication 1 et 2, caractérisé par le fait que les émetteurs des transistors ($T_{11}$, $T_{12}$; $T_{21}$, $T_{22}$; ...; $T_{N1}$, $T_{N2}$) sont reliés chacun, par l'intermédiaire d'une résistance d'émetteur ($R_{11}$, $R_{12}$; $T_{21}$, $R_{22}$; ...; $T_{N1}$, $R_{N2}$), à respectivement une source de courant constant ($I_1$, $I_2$, ..., $I_N$).

4. Montage selon la revendication 1 et 2, caractérisé par le fait que les émetteurs des transistors ($T_{11}$, $T_{12}$; $T_{21}$, $T_{22}$; ...; $T_{N1}$, $T_{N2}$) de chacun des amplificateurs. différentiels sont couplés directement et sont reliés, par l'intermédiaire d'une résistance d'émetteur commune ($R_{E1}$, $R_{E2}$, ..., $R_{EN}$), à une source de courant constant (I).

0 044 047

FIG 1

FIG 2

1

0 044 047

FIG 3